# EUROPEAN PATENT SPECIFICATION

(11) **EP 2 975 771 B1**
(45) Date of publication and mention of the grant of the patent: **30.12.2020**
(21) Application number: 14177503.1
(22) Date of filing: 17.07.2014
(51) Int. Cl.: H03M 7/40, H03M 7/30, G06T 9/00

(54) **A METHOD FOR SELECTING STARTING POSITIONS IN PARALLEL DECODING OF A COMPRESSED IMAGE**
VERFAHREN ZUR AUSWAHL VON STARTPOSITIONEN BEI PARALLELER DECODIERUNG EINES KOMPRIMIERTEN BILDES
PROCÉDÉ DE SÉLECTION DE POSITIONS DE DÉPART DANS LE DÉCODAGE PARALLÈLE D'UNE IMAGE COMPRESSÉE

(43) Date of publication of application: 20.01.2016
(73) Proprietor: Phase One A/S, 2000 Frederiksberg (DK)
(72) Inventor: Høgh-Rasmussen, Esben, 2200 København N (DK)
(74) Representative: Aera A/S

(56) References cited:
- GUANGCAI ZHOU ET AL: "Synchronization Recovery of Variable-Length Codes", IEEE TRANSACTIONS ON INFORMATION THEORY, IEEE PRESS, USA, vol. 48, no. 1, 1 January 2002 (2002-01-01), XP011028136, ISSN: 0018-9448
- PATRICK J S ET AL: "JPEG compression/decompression via parallel processing", SIGNALS, SYSTEMS AND COMPUTERS, 1996. CONFERENCE RECORD OF THE THIRTIE TH ASILOMAR CONFERENCE ON PACIFIC GROVE, CA, USA 3-6 NOV. 1996, LOS ALAMITOS, CA, USA,IEEE COMPUT. SOC, US, 3 November 1996 (1996-11-03), pages 596-600vol.1, XP032133771, DOI: 10.1109/ACSSC.1996.601094 ISBN: 978-0-8186-7646-8
- E. N. GILBERT ET AL: "Variable-Length Binary Encodings", BELL SYSTEM TECHNICAL JOURNAL, vol. 38, no. 4, 1 July 1959 (1959-07-01), pages 933-967, XP055170640, ISSN: 0005-8580, DOI: 10.1002/j.1538-7305.1959.tb01583.x
- FREILING C F ET AL: "Almost all complete binary prefix codes have a self-synchronizing string", IEEE TRANSACTIONS ON INFORMATION THEORY, IEEE PRESS, USA, vol. 49, no. 9, 1 September 2003 (2003-09-01), pages 2219-2225, XP011100220, ISSN: 0018-9448, DOI: 10.1109/TIT.2003.815803
- KLEIN; WISEMAN: "Parallel Huffman Decoding with Applications to JPEG Files", THE COMPUTER JOURNAL, vol. 46, no. 5, 2003, XP002736182,

## Description

### FIELD OF THE INVENTION

The present invention relates to decoding of compressed image files.

### BACKGROUND OF THE INVENTION

Several file formats and transmission protocols have long contiguous sequences of data encoded as a sequence of code-words of variable lengths. Examples of such formats includes, but are not limited to, graphics formats such as JPEG (both lossy and unlossy modes), RAW files stored by digital cameras, compressed archives and more. Many codes are prefix-free codes, which imply a symbol can be decoded as soon as the code-word has been received.

### Prefix-free codes and extensions

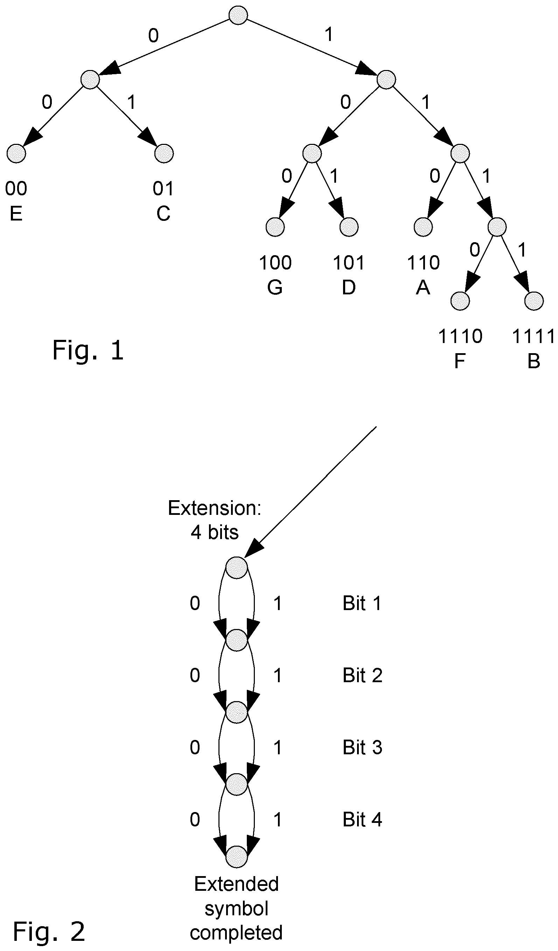

A common way to construct a prefix-free code is via the Huffman algorithm, but other approaches (for example the Shano-Fano algorithm) are possible. A prefix-free code can be represented as a binary tree as shown in Figure 1, which is a code tree for the symbols A, B, ..., G.

In the simplest case, a sequence of symbols is encoded by concatenating the code-words that represent each symbol. Sometimes a long code is constructed by extending a simpler code. A good example is given by the JPEG standard: a signed integer may be encoded as a prefix-free code (possibly derived using the Huffman algorithm) to encode the number of bits required to represent the value. This is followed by the bits specified and these together represent the desired value. This encodes values in different ranges as shown in the following table:

| Symbol extension (in bits) | Values |
|---|---|
| 0 | 0 |
| 1 | -1, +1 |
| 2 | -3,-2,+2,+3 |
| 3 | -7,-6,-5,-4,+4,+5,+6,+7 |
| 4 | -15,...,-8, +8,...,+15 |
| *n* | 1 - 2*ⁿ*, ..., -2^{*n*-1},2^{*n*-1}, ..., 2*ⁿ* - 1 |

The code-word and the extension bits are considered as a single symbol for the purpose of this text. While the full tree for such a code could be very large, there are several ways to represent such a tree compactly if we are mainly interested in finding the start of a new symbol. For example, a leaf node may store the number of bits in the extended code. The JPEG (lossy and unlossy modes) referenced in this document is standardized by ISO: JPEG ISO/IEC 10918-1 ITU-T Recommendation T.81.

A more general solution is to use a graph (such as a Directed Acyclic Graph or DAG) instead of a tree. For example, we may represent a 4-bit extension of a symbol as shown in Figure 2.

Many image formats use multiple alternating codes. Again lossy JPEG-compression provides an example: a block of 8x8 coefficients is encoded with two separate codes: a symbol representing a DC-value followed by (at most) 63 symbols representing AC-coefficients.

Some files created by digital cameras encode a sequence by alternating between codes that encodes lightness and chroma. Hence these sequences alternate between two or three different codes.

It is possible to represent alternating codes as a graph for a very long codeword. In this case, the last node of a symbol would point to a node representing the first node of the following symbol. However, it is usually more economical to represent this by other means. For example, to it quite economical to represent one of the 63 AC-coefficients of a JPEG block by referring to the shared code for the AC-coefficients as well as its number (e.g. "coefficient 5"). In contrast, representing a block as a single graph would require 63 copies of the AC-code.

Decoding large compressed files is often a limiting factor in the speed of working with such files. It is therefore often desirable to speed up this decoding process so that the user does not experience long delays when trying to access an encoded file. For compressed images, this would for example mean that when a user wants to access the full image and not just a preview, he often encounters delays of several seconds while the compressed image is being decoded. One way to reduce the delay is to decode different parts of the sequence simultaneously. Unfortunately, the bit-sequence is inherently serial making this difficult unless extra information is stored in the file.

Klein and Wiseman ("Parallel Huffman Decoding with Applications to JPEG Files", The Computer Journal, Vol. 46, No. 5, 2003) describes a procedure for parallel decoding of Huffman encoded files and applies this to JPEG files. The procedure is used to decode blocks of variable length, prefix-free code-words of a compressed sequence in parallel, which can speed up the decoding of the entire file. However, since the block-boundaries do not necessarily coincide with code-word boundaries, the beginning of each block is subject to erroneous decoding until synchronisation between the decoded and the originally encoded words has been achieved. With the suggested procedure, it is unpredictable if or when synchronisation for a given block is achieved and thus for how long the erroneous decoding is going on. In addition, the only way for the described procedure to check whether synchronisation has been achieved for a given block, is to let the previous block overflow and continue decoding in the consecutive block until it can be checked by comparison whether synchronization has occurred. This checking must start with the first block which is inherently correctly decoded, and thus blocks should be decoded successively.

It is well known that natural convergence or resynchronization often occurs in variable length, prefix-free codes, see e.g. Zhou G et al., "Synchronization Recovery of Variable-Length Codes", IEEE Transactions on Information Theory, Vol. 48, No. 1, 1 January 2002, pp 219-227, Gilbert EN et al., "Variable-Length Binary Encodings", Bell System Technical Journal, Vol. 38, No. 4, 1 July 1959, pp 933-967, or Freiling CF et al., "Almost all complete binary prefix codes have a self- synchronizing string", IEEE Transactions on Information Theory, Vol. 49, No. 9, pp 2219-2225. For some codes, the mean number of bits it takes for the decoding to naturally resynchronize can even be calculated (mean error propagation length (MEPL) in Zhou et al.).

Relying on natural resynchronization when decoding means relying on statistical properties of the encoded sequence. This has the limitations of 1) natural resynchronization does not occur in all variable length, prefix-free codes, and 2) since it is a statistical property, the decoding will only be error-free when the actual point of resynchronization coincidentally coincides with the mean value. Whereas it is quite common to allow for short data sequences not being correctly decoded in communication systems where very long sequences occur, this is not acceptable for an industrial strength decoder. In order to decode the entire sequence correctly, it is generally necessary to determining where synchronization has actually occurred. Thereby, the bits that where erroneously decoded before the decoding was synchronized can be correctly decoded afterwards. This is not possible when natural resynchronization is relied upon, since the point of resynchronization is not known.

Several ways to prepare compressed files for parallelized decoding exist, several of which are mentioned in Klein and Wiseman and Zhou et al. For example, the JPEG standard allows a sequence to embed restart markers which could be used to delineate sub-sequences, but these markers are almost never found in images from cameras. The present invention aims at the cases where files are not prepared for parallel decoding and where neither the encoding process nor the encoded data can be influenced to implement such preparation.

Hence, a way of increasing the speed of decoding compressed files would be advantageous, and in particular an improved procedure for decoding several sub-sequences of such files in parallel would be advantageous. More particularly, a more efficient and/or reliable way of bringing the decoding into synchronisation with the encoded sequence and determining when the synchronisation has been achieved would be advantageous.

### SUMMARY OF THE INVENTION

It may be seen as an object of the present invention to provide a method that solves the above mentioned technical problems of the prior art with increasing the speed of decoding compressed image files.

Thus, the above described object and several other objects are intended to be obtained in a first aspect of the invention by providing a method for decoding a selected sub-sequence within a sequence of encoded symbols in a compressed image file, where the sub-sequence does not comprise the beginning of the encoded sequence and the symbols are encoded as variable length prefix-free code-words, as defined by claim 1.

As can be seen from the above section "Prefix-free codes and extensions", there are a large number of very different ways to encode a sequence of symbols to a sequence of code-words of variable lengths. The format of the code, meaning which algorithm(s) are used to encode what and where is for the purpose of this description referred to as the *encoding format information.* Since a tree is a kind of graph, graph is used to also cover a tree. The graph used to represent the encoding format information at any specified position in the encoded sequence is referred to as the *graph of the encoding format information* or in short the *graph or tree* or simply the *graph,* the relevant position and encoding format information being given in the context.

Selecting *S* so that it includes at least one synchronization state that would correctly decode the remainder of the sub-sequence is a question of applying logic when selecting *S**.*** The intention is that the states in *S* are selected so that one will at some point in the iterative procedure hit upon a state (i.e. a link between a specific node and a specific position in the sequence) that one would also have hit upon if one had decoded the entire sequence from the beginning. When such a state has been determined, the decoding of the remainder of the sub-sequence will be identical to the decoding one would arrive at when decoding from the beginning of the sequence. By selecting states that covers enough positions and nodes, one can be sure that S includes such a state. However, choosing the states in *S* with some consideration would reduce the number of states in *S* and thereby the efficiency of the procedure.

An *invalid state* is a state which could not be found in an encoded sequence. Lossy JPEG provides an example: the AC-coefficients are encoded by a sequence of symbols which represents the number of zero coefficients that precedes the next non-zero coefficient. For example, a state representing AC-coefficient 60 at a certain position in the sequence would be recognized as an invalid state if it was followed by a symbol that represented a run of 8 zero coefficients (there are at most 63 non-zero AC coefficients).

In a preferred embodiment, defined by claim 2, the method further comprises the following step: 2a. if the set of states, *S*, is empty, stop the iteration and return with failure. In this case, the sub-sequence is an invalid sub-sequence. Such a sequence would never be created by a correct encoder, which means an incorrect code is used or the sequence was erroneously transmitted.

Instead of letting the sequences continue into the following sequences to accommodate for the initial, not-decoded parts of the sub-sequences, the sub-sequences can be adjusted after the synchronization state have been determined and before decoding starts. The adjusted sub-sequences may then begin at a position associated with the determined synchronization states and end at the next determined synchronization state (except that the first and last sub-sequence will begin/end at the first/last bit of the sequence, respectively).

The invention may be implemented by means of hardware, software, firmware or any combination of these. Thus, in a further aspect, the invention relates to a digital storage holding software as defined by independent claim 4 and an integrated circuit configured to perform the method of claim 1, as defined by independent claim 5.

The invention is particularly, but not exclusively, advantageous for determining a synchronization state in a sub-sequence that will correctly decode the remainder of the sub-sequence. The invention thereby provides a way of bringing the decoding of a sub-sequence into synchronisation with the encoded subsequence that has the following advantages over the prior art:
- It is clear and consistent when synchronization is obtained. With the natural convergence discussed in Klein and Wiseman, it is not known whether synchronization has occurred until the decoded symbols can be checked against the symbol decoded by the overflow of the previous sub-sequence. Therefore, all the decoded symbols need to be stored until then. With the method according to the invention, the symbols decoded during the determination of a synchronization state need not be stored, meaning that the method requires less storage capacity.
- Efficient and predictable. The previous sub-sequence need only overflow to the determined synchronization state, and the overall overflow can thus be minimized.
- Faster, the above advantages allows for the sequence to be cut into more subsequences so that more decoding processes can run in parallel.

In end effect, the invention provides the advantage that the speed of decoding of compressed files can be increased in that several sub-sequences of such files can be decoded in parallel.

The individual aspects of the present invention may each be combined with any of the other aspects. These and other aspects of the invention will be apparent from the following description with reference to the described embodiments.

The gist of the present invention is to determine a synchronization state in a sub-sequence from where the remainder of the sub-sequence can be correctly decoded without referring to any part of the sequence preceding the sub-sequence.

### BRIEF DESCRIPTION OF THE FIGURES

The invention will now be described in more detail with regard to the accompanying figures. The figures show one way of implementing the present invention and is not to be construed as being limiting to other possible embodiments falling within the scope of the attached claim set.
Figure 1 is an example of a binary tree representing a prefix-free code for the symbols A, B, ..., G.
Figure 2 is a Directed Acyclic Graph (DAG) representing a 4-bit extension of a symbol.
Figure 3 is a flow diagram illustrating a procedure to determine a synchronization state where the remaining sequence can be correctly decoded. It is also a schematic system-chart representing an out-line of the operations of the computer program product according to the invention.
Figure 4 illustrates the procedure for determining a synchronization state for a sub-sequence using the code-tree in Figure 1, where a state can be represented as a single position and the node where a new symbol begins. The initial set of states is given by all positions up to the longest code-word.
Figure 5 illustrates queues in shift registers in a hardware implementation of an embodiment of the invention.
Figure 6 is a DAG with a single root and a single leaf node that could be used instead of the tree in Figure 1 to determine the root node.
Figure 7 illustrates the result of splitting a sequence into 6 sub-sequences of approximately the same length. After running the procedure to determine synchronization states on each sub-sequence, except the first, we find 5 sub-sequences starting at a known synchronization state.

### DETAILED DESCRIPTION OF THE INVENTION

The following description first provides a more detailed discussion of decoder states and the different ways to select a set of states. Thereafter, a method for finding a starting state for decoding will be described in more detail, as well as hardware and software implementations of this method. Thereafter, embodiments for using the method to decode a sub-sequence as well as parallelized decoding of an entire sequence will be described. Lastly, the distribution of parallelized decoding on more processors will be described.

### Decoder states

A decoder for a prefix-free code can be constructed by going through the sequence of bits while following a graph as described in relation to figures 1 or 2, associating each position in the sequence with a node in the graph. At any given time, the decoder is in a state associated with one position in the sequence being decoded and a node in the graph. The state may be represented differently depending on the way the encoding format information is constructed; for example, a state may be associated with a node in an AC-tree and a separate coefficient number. If the code is an extension code, and the leaf nodes store the number of bits, a state could include the node and the number of extension bits decoded at the associated position in the sequence. A node alone or a position alone cannot be a state, a state is always associated with both a node and a position. In special situations where one node/position is common to all positions/nodes can a position/node alone define a state uniquely. In these cases where all states share a single position or node, it is not necessary to store this information in the state explicitly.

Normally, the decoder starts in a well-defined state, typically the first position in the encoded sequence and the root node in the relevant graph, and follows the graph by following the bits in the sequence. When an attempt is made to jump to a random position inside the sequence and start decoding from there, the starting state of the decoder is unknown (the position in the sequence is given, but the associated node in the graph is not known). Thus, even if the correct graph were used, the decoded sequence would most likely not be in synchronization with the original sequence.

Typically, there are one or more nodes in the graph that are natural locations to start decoding. For a simple code, with a single decode tree, a natural state would be one associated with the beginning of a new symbol, i.e. any state associated with the root node. In a complex code, such as lossy JPEG, it is more natural to start decoding at the start of a DC coefficient. We shall refer to nodes in the decode graph that represent natural locations as *synchronization nodes.* We shall refer to a state associated with a synchronization node as a *synchronization state.* One may choose to let any node in the graph be a synchronization node, since as soon as one can with certainty link a specific node in a specific graph to a specific position in the sub-sequence, the decoding is in synchronization. It is, however, often desirable to have only one or at most a few synchronization nodes in the graph.

### Selecting a set of states

Given a position, *p*, inside a sequence without looking at the preceding data or knowing which symbol is currently being decoded, we may select an initial set of synchronization states, *S*, that will necessarily include at least one synchronization state which would correctly decode the remaining sequence.

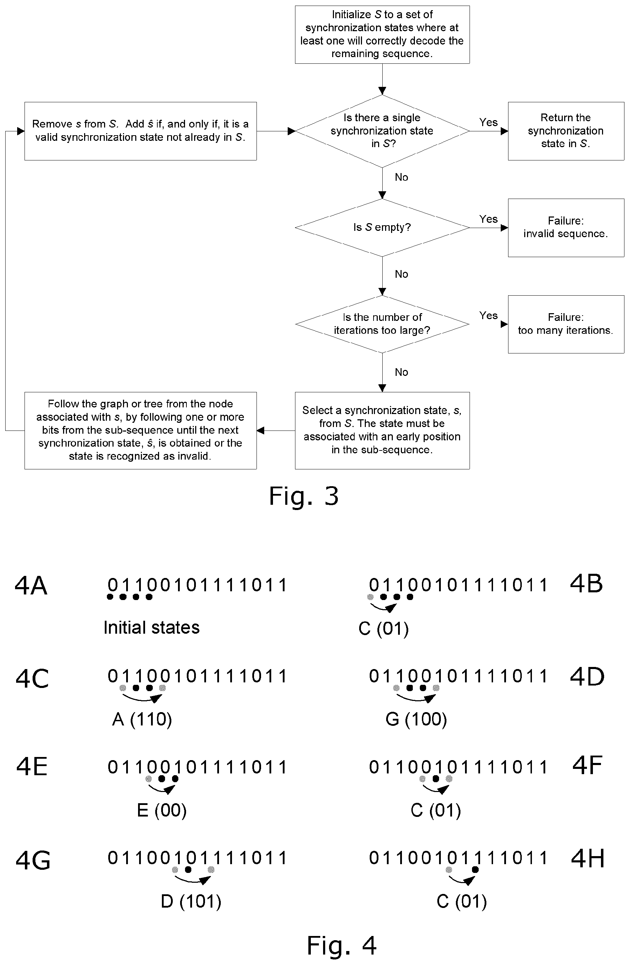

There are several useful ways to select such a set of states. One simple, albeit somewhat inefficient, set of synchronization states that will necessarily include a state that would correctly decode the remaining sub-sequence, is the set of states associated with all synchronization nodes at each of the positions in the set {*p*, *p*+1, *p*+2,...,*p*+*L*-1}, where *L* is the largest number of bits required to transition from one synchronization state to another in the graph. Later in relation to Figure 4A-H, an example of such a set with only a single synchronization node will be described.

Another way to select a set of states is possible if all non-leaf nodes in the graph are chosen as synchronization nodes. In this case, the states would be a single position and be associated with each of the nodes in the graph. In this case, the set of all nodes in the graph would necessarily include a state that would correctly decode the remaining sequence starting from that single position.

### Finding a starting state for the decoder

Once we have selected *S* the following procedure is then run:
- if the set of states, *S*, only contains a single state, use this state as the determined synchronization state from where the remainder of the sub-sequence can be correctly decoded and stop the iteration;
- select a state, *s*, from *S*, *s* being associated with the earliest position in *S* and, starting from the node and the position associated with *s*, follow the graph of the encoding format information by following bit(s) in the sub-sequence until a next synchronization state, ŝ, has been obtained or a next state is recognized as invalid;
- remove *s* from *S* and add *ŝ* to *S* if *ŝ* is a valid state not already in *S*; and
- start again.

Once the number of states in *S* have been reduced to one, we have found the determined synchronization state from which the remainder of the sub-sequence will be decoded correctly, and decoding can proceed as normal. It is only necessary to keep states for at most *L*+1 positions, since the position can advance by at most *L* and we always select a symbol in earliest position.

This procedure can be summarized in the diagram shown in Figure 3.

A simple example is described here with reference to Figure 4. Say that the symbols AACCFB... are encoded by the code tree given in Figure 1, so that the encoded sequence is "110-110-01-01-1110-1111...". Creating a sub-sequence by removing the first 2 bits, we want to determine a synchronization state of a sub-sequence starting with "01100101111011...". If we have chosen to have only a single synchronization node in the graph, a synchronization state is fully specified by the position in the sequence since the associated synchronization node is common to all states. In this case we choose the root node as the single synchronization node, so that each synchronization state will be the start of a new symbol. Since the longest code-word is 4 bits (symbols B and F), it is sufficient to initialize the set to the first four positions in the sequence. The procedure can then proceed as shown in Figures 4A-H:
- 4A: - The initial set *S* is the first 4 positions in the sub-sequence, i.e. 0110.
- The earliest position is the first position, having bit value 0, hence we select this state and start following the tree of Figure 1 by following the sub-sequence from the first position. We start at the root node of the tree since we have chosen that as the single synchronization node common to all positions.
- 4B: - We follow the tree by following the bits until we arrive at a leaf node (here the node encoding a C) since we have chosen that synchronization states are always the start of a new symbol and thus associated with the root node. The next synchronization state is associated with position 3 to where the arrow points.
- The state associated with position 1 is removed from the set, *S*, and since the state associated with position 3 is already in *S*, it is not added.
- *S* now consists of the states associated with positions 2-4.
- 4C: - We again select the state with the earliest position, this time position 2.
- After following the tree (starting at the root node) by following the bits from position 2 we arrive at the leaf node encoding an A, and the next synchronization state is position 5 to where the arrow points.
- Position 2 is removed and position 5 is added since it is not already in *S.*
- *S* now consists of positions 3-5.
- 4D: - We again select the state with the earliest position, this time position 3.
- After following the tree from the root node by following the bits from position 3 we arrive at the leaf node encoding a G, and the next synchronization state is position 6 to where the arrow points.
- Position 3 is removed and position 6 is added since not already in *S.*
- *S* now consists of positions 4-6.
- 4E: - We again select the state with the earliest position, this time position 4.
- After following the tree we arrive at the leaf node encoding an E, the next synchronization state is position 6.
- Position 4 is removed but position 6 is not added since it is already in *S.*
- *S* now consists of positions 5-6.
- 4F: - We start from position 5.
- After following the tree to arrive at the leaf node (C), the next synchronization state is position 7.
- Position 5 is removed and position 7 is added since not already in *S.*
- 4G: - We start from position 6.
- After following the tree to arrive at the leaf node (D), the next synchronization state is position 9.
- Position 6 is removed and position 9 is added since not already in *S.*
- *S* now consists of positions 7 and 9 (note that the state associated with position 8 is skipped).
- 4H: - We start from position 7.
- After following the tree to arrive at the leaf node (C), the next synchronization state is position 9.
- Position 7 is removed but position 9 is not added since already in *S.*
- *S* now consists of only one synchronization state, the one associated with the root node at position 9, which is then the determined synchronization state.

By following the procedure above, we see that only a single synchronization state (position 9) is left after 7 steps where the 8 bits have been consumed. Once this state has been found, decoding can proceed the same way the code would normally be decoded, the first decoded symbol being F, which is in synchronization with the original encoded sequence.

### Implementations

The invention can be implemented by means of hardware, software, firmware or any combination of these. The invention or some of the features thereof can also be implemented as software running on one or more data processors and/or digital signal processors.

### Hardware implementation

One way to implement the procedure is to have a queue with at least *L* + 1 shift registers. Each register contains a bit per synchronization node; this bit represents whether *S* contains a synchronization state associated with the node at this position. Since each register belongs to a position, it is convenient to hold the corresponding bit from the sequence in the register as well.

One implementation of the procedure goes as this:
1. Initialize the registers in the queue with bits from the sequence and states as previously described. Also keep a counter with the number of states included in the set.
2. Stop if the state counter is one and the first register in the queue indicates a state.
3. Stop if the state counter is zero.
4. Look at the first register in the queue and check if any synchronization states starts at this position.
5. For each synchronization state indicated by the register, follow the decode graph using the bits kept in the queue. There are several outcomes:
   a) If the state is recognized as invalid, decrease the state counter.
   b) Otherwise check if the resulting state bit is set; if it is, decrease the state counter and otherwise set the state to indicate a valid synchronization state.
6. Shift out the first register in the queue and shift in a new state with no state bits set and the next input bit from the input sequence.
7. Go to step 2.

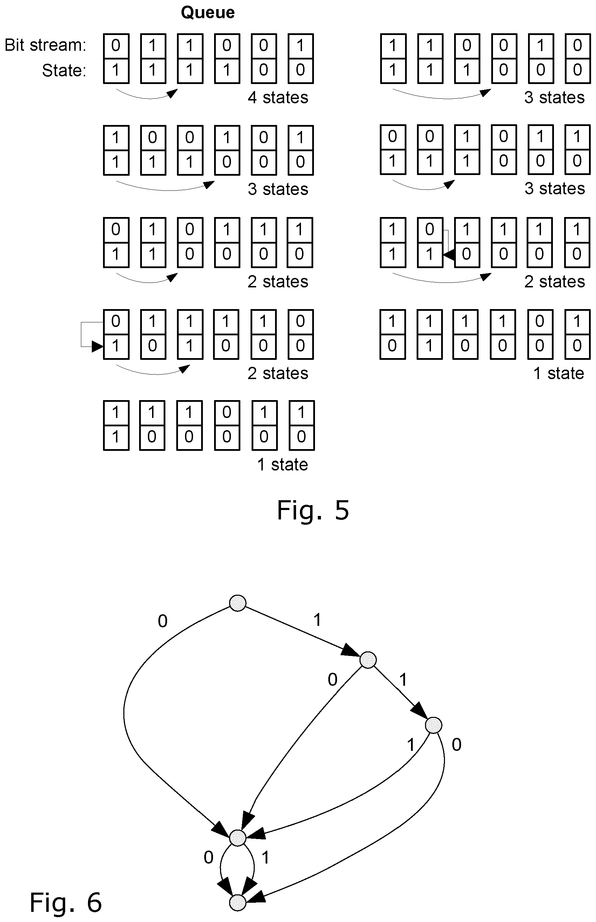

In this embodiment, using a queue of length 6, the previous example runs as shown in Figure 5. At this point, a synchronization state has been determined after consuming 8 bits of the sub-sequence and decoding can start using a standard decoder.

A hardware implementation can be embodied by an integrated circuit configured to perform the procedure outlined above, or any other embodiment of the method according to the invention. Such an integrated circuit may for example be an ASIC (application-specific integrated circuit) or a FPGA (field-programmable gate array).

### Software implementation

The flow chart of Figure 3 can be seen as a schematic system-chart representing an out-line of the operations of a software implementation according to an embodiment of the invention. In more detail, a software implementation could closely imitate the procedure described in the hardware implementation. However, a software implementation can more easily accommodate complex representations of a state. For example, states corresponding to a single position could be represented by a pointer to a node in the graph. This makes it relatively easy to implement a procedure that takes a decode graph as input.

A software implementation can more easily accommodate a large amount of synchronization nodes than a hardware implementation. For example, one could use all nodes in a decode graph as synchronization states and only update a state by a single bit at each iteration. A more practical way to do that would be to use a compressed graph which share internal nodes where possible. For example, the graph in Figure 6, a DAG with a single root and a single leaf node, could be used instead of the tree in Figure 1 to determine the root node..

In practice is it probably best to use a modest number of synchronization states. For example, a useful set of states that can be used to find a synchronization state in a sub-sequence from a lossy JPEG file is the start of a DC-coefficient as well as the start of one of the 63 AC-coefficients. This can be encoded in 64 bits per position, and the AC coefficients can be handled by a routine that treats all coefficients at once.

### Decoding a selected sub-sequence

Once a single synchronization state has been determined, decoding can start at that state using a standard decoder.

### A method for decoding a compressed image

A compressed image file, which contains a long sequence of symbols encoded as variable length code-words, can be split into several sub-sequences. Assume we have split a sequence into a number of sub-sequences of approximately equal length. We may now run the procedure described earlier to find synchronization states for each sub-sequence (except the first for which the initial state is known). We may then partition the sequence into sub-sequences at positions where a synchronization state is found.

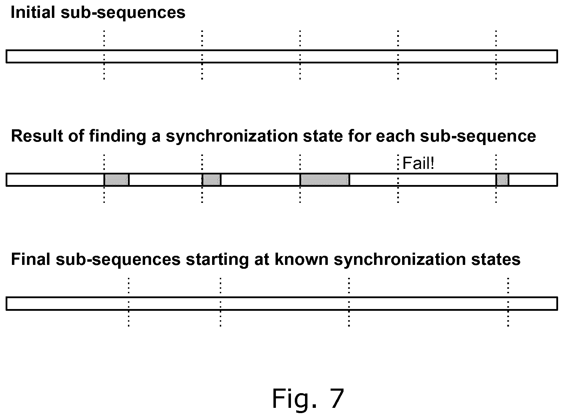

Consider the example in Figure 7, illustrating the result of splitting a sequence into 6 sub-sequences of approximately the same length. After running the procedure to find synchronization states on each sub-sequence, except the first, one finds 5 sub-sequences starting at a determined synchronization state. Since the sub-sequences determined by this algorithm starts at known synchronization states, the sub-sequences can be decoded individually. After decoding each sub-sequence, the resulting decoded sub-sequences can be concatenated to form the fully decoded sequence.

The individual elements of an embodiment of the invention may be physically, functionally and logically implemented in any suitable way such as in a single unit, in a plurality of units or as part of separate functional units. The invention may be implemented in a single unit, or be both physically and functionally distributed between different units and processors.

### A method for decoding a compressed image on one or more digital processing units

If we wish to decode a sequence on multiple processing units, we can first split the sequence into a number of sub-sequences as described in the previous section. For effectiveness, the typical number of bits required to determine a synchronization state should be small compared to the length of the initial sub-sequences. Since the sequence is encoded using variable length code-words, sub-sequences of equal length will generally decode to sequences of different length. As a result, sub-sequences may take different times to decode even if they are of equal length.

For this reason, and due to the fact that the procedure may fail to find a synchronization state for a particular sub-sequence, it is probably best to split the sequence into a somewhat larger number of sub-sequences than the number of processors intended to be used. For example, if N processors are available for decoding, we may try to split the sequence into 4*N* sub-sequences.

However, we still limit the sub-sequences in such a way that a sub-sequence is not too small. For example, we may ensure the initial sub-sequences are at least 128 x 1024 x 8 bits. Since we need to read a part of the file to determine how to split the file into sub-sequences, the minimum size of each sub-sequence depends on the time it takes to read the first part of a sub-sequence. On a modern general-purpose computer, a wide range of values works well.

It should be noted that determining the synchronization states for the sub-sequences are independent of each other. It is therefore possible to split a sequence into sub-sequences by utilizing all computational units. Once the sequence is split into sub-sequences, the sub-sequence can be decoded on individual computational units.

Since there is some overhead associated with using multiple computational units, notably for concatenating the results after decoding, it is best to avoid decoding on multiple processing units if the largest sub-sequence is a significant fraction of the original sequence.

To maximize utilization of all computational units, and since sub-sequences are not the same length, it is best to decode the longest sub-sequences first. It is possible to improve load balancing across different processing units even further by selecting the initial sub-sequences of different lengths. This ensures that all processing units will complete at roughly the same time.

Although the present invention has been described in connection with the specified embodiments, it should not be construed as being in any way limited to the presented examples. The scope of the present invention is to be interpreted in the light of the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. A method for decoding a compressed image file comprising symbols encoded as a sequence of variable length prefix-free code-words, the method comprising the steps of:
• dividing the encoded sequence into two or more successive initial sub-sequences;
• for each initial sub-sequence not comprising the beginning of the encoded sequence, determining a synchronization state for decoding by performing the following steps iteratively:
1. select a set of synchronization states, *S,* each state being associated with a position in the initial sub-sequence and a synchronization node in a graph of the encoding format information relevant to the initial sub-sequence, *S* being selected so that it includes at least one synchronization state that would correctly decode the remainder of the initial sub-sequence;
2. if the set of states, *S*, only contains a single state, use this state as the determined synchronization state and stop the iteration;
3. if the set of states, *S*, does not contain a single state only, select a state, *s*, from *S*, *s* being associated with the earliest position in *S* and, starting from the node and the position associated with *s*, follow the graph of the encoding format information by following bit(s) in the initial sub-sequence until a next synchronization state, *ŝ*, has been obtained or a next state is recognized as invalid;
4. remove *s* from *S* and add *ŝ* to *S* if *ŝ* is a valid state not already in *S*; and
5. start again from step 2;
• partitioning the encoded sequence into successive final sub-sequences where each final sub-sequence not comprising the beginning of the encoded sequence begins at a determined synchronization state;
• decoding each final sub-sequence in parallel; and
• concatenating the decoded final sub-sequences to obtain a decoded image file.

2. The method according to claim 1, further comprising the following step: 2a. if the set states, *S*, is empty, stop the iteration and return with failure.

3. The method according to claim 1 or 2, further comprising the following step: 2b. if the number of iterations is larger than a pre-set limit then return with failure.

4. A digital storage holding software configured to perform the method of claim 1 when executed by one or more digital processing units.

5. An integrated circuit configured to perform the method of claim 1.

6. A handheld camera comprising the digital storage according to claim 4 or the integrated circuit according to claim 5.

## Patentansprüche

1. Verfahren zum Decodieren einer komprimierten Bilddatei, die Symbole umfasst, die als Sequenz von längenvariablen präfixfreien Codewörtern codiert sind, wobei das Verfahren die folgenden Schritte umfasst:
• Unterteilen der codierten Sequenz in zwei oder mehr aufeinanderfolgende anfängliche Teilsequenzen;
• für jede anfängliche Teilsequenz, die nicht den Beginn der codierten Sequenz umfasst, Bestimmen eines Synchronisationszustands zum Decodieren durch iteratives Durchführen der folgenden Schritte:
1. Auswählen eines Satzes von Synchronisationszuständen, *S,* wobei jeder Zustand mit einer Position in der anfänglichen Teilsequenz und einem Synchronisationsknoten in einem Graphen der Codierungsformatinformationen, die für die anfängliche Teilsequenz relevant sind, assoziiert ist, wobei *S* so ausgewählt wird, dass er mindestens einen Synchronisationszustand beinhaltet, der den Rest der anfänglichen Teilsequenz korrekt decodieren würde;
2. falls der Satz von Zuständen, S, nur einen einzigen Zustand enthält, Verwenden dieses Zustands als den bestimmten Synchronisationszustand und Anhalten der Iteration;
3. falls der Satz von Zuständen, *S*, nicht nur einen einzigen Zustand enthält, Auswählen eines Zustands, *s*, aus *S*, wobei s mit der frühesten Position in *S* assoziiert ist, und startend ab dem Knoten und der Position, die mit *s* assoziiert ist, dem Graphen der Codierungsformatinformationen Folgen, indem (einem) Bit(s) in der anfänglichen Teilsequenz gefolgt wird, bis ein nächster Synchronisationszustand, *ŝ*, erlangt worden ist oder ein nächster Zustand als ungültig erkannt wird;
4. Entfernen von *s* aus *S* und Hinzufügen von *ŝ* zu *S,* falls *ŝ* ein gültiger Zustand ist, der sich nicht bereits in S befindet; und
5. erneutes Starten ab Schritt 2;
• Zerlegen der codierten Sequenz in aufeinanderfolgende endgültige Teilsequenzen, wobei jede endgültige Teilsequenz, die nicht den Beginn der codierten Sequenz umfasst, bei einem bestimmten Synchronisationszustand beginnt;
• paralleles Decodieren jeder endgültigen Teilsequenz; und
• Konkatenieren der decodierten endgültigen Teilsequenzen, um eine decodierte Bilddatei zu erlangen.

2. Verfahren nach Anspruch 1, ferner umfassend den folgenden Schritt: 2a. falls der Satz von Zuständen, *S*, leer ist, Anhalten der Iteration und Ausgeben eines Fehlers.

3. Verfahren nach Anspruch 1 oder 2, ferner umfassend den folgenden Schritt: 2b. falls die Anzahl von Iterationen größer als ein im Voraus festgelegter Grenzwert ist, dann Ausgeben eines Fehlers.

4. Digitaler Speicher, in dem Software aufbewahrt ist, die dazu konfiguriert ist, das Verfahren nach Anspruch 1 durchzuführen, wenn sie durch eine oder mehrere digitale Verarbeitungseinheiten ausgeführt wird.

5. Integrierter Schaltkreis, der dazu konfiguriert ist, das Verfahren nach Anspruch 1 durchzuführen.

6. Handkamera, umfassend den digitalen Speicher nach Anspruch 4 oder den integrierten Schaltkreis nach Anspruch 5.

## Revendications

1. Procédé de décodage d'un fichier image compressé comprenant des symboles codés sous la forme d'une séquence de mots de code sans préfixe de longueurs variables, le procédé comprenant les étapes :
• de division de la séquence codée en deux sous-séquences initiales successives ou plus ;
• pour chaque sous-séquence initiale ne comprenant pas le début de la séquence codée, de détermination d'un état de synchronisation pour le décodage en exécutant les étapes suivantes de manière itérative :
1. la sélection d'un ensemble d'états de synchronisation, S, chaque état étant associé à une position dans la sous-séquence initiale et à un nœud de synchronisation dans un graphique des informations de format de codage relatives à la sous-séquence initiale, *S* étant sélectionné de sorte qu'il inclut au moins un état de synchronisation qui décoderait correctement le reste de la sous-séquence initiale ;
2. si l'ensemble d'états, *S*, contient uniquement un état unique, l'utilisation de cet état comme état de synchronisation déterminé et l'arrêt de l'itération ;
3. si l'ensemble d'états, *S,* ne contient pas uniquement d'état unique, la sélection d'un état, *s*, à partir de *S, s* étant associé à la position la plus ancienne dans *S* et, à partir du nœud et de la position associés à s, le suivi du graphique des informations de format de codage en suivant le(s) bit(s) dans la sous-séquence initiale jusqu'à ce qu'un état de synchronisation suivant, *ŝ*, ait été obtenu ou qu'un état suivant soit reconnu comme invalide ;
4. le retrait de *s* de *S* et l'ajout de *ŝ* à *S* si *ŝ* est un état valide qui n'est pas déjà dans *S* ; et
5. le recommencement à partir de l'étape 2 ;
• de séparation de la séquence codée en sous-séquences finales successives où chaque sous-séquence finale ne comprenant pas le début de la séquence codée commence à un état de synchronisation déterminé ;
• de décodage de chaque sous-séquence finale en parallèle ; et
• de concaténation des sous-séquences finales décodées pour obtenir un fichier image décodé.

2. Procédé selon la revendication 1, comprenant en outre l'étape suivante : 2a. si l'ensemble des états, *S,* est vide, l'arrêt de l'itération et le renvoi d'un code d'erreur.

3. Procédé selon la revendication 1 ou 2, comprenant en outre l'étape suivante : 2b. si le nombre d'itérations est supérieur à une limite prédéfinie, le renvoi d'un code d'erreur.

4. Logiciel de maintien de stockage numérique configuré pour exécuter le procédé selon la revendication 1 lorsqu'il est exécuté par une ou plusieurs unités de traitement numérique.

5. Circuit intégré configuré pour exécuter le procédé selon la revendication 1.

6. Caméra portable comprenant le stockage numérique selon la revendication 4 ou circuit intégré selon la revendication 5.
